# EUROPEAN PATENT APPLICATION

(11) **EP 3 591 719 A1**
(43) Date of publication of application: **08.01.2020**
(21) Application number: 17898497.7
(22) Date of filing: 04.12.2017
(51) Int. Cl.: H01L 31/048, H01L 31/054

(54) **HIGHLY REFLECTIVE GAIN TYPE PHOTOVOLTAIC PACKAGING ADHESIVE FILM AND USAGE**

(30) Priority: 03.03.2017 CN 201710124638
(71) Applicant: Hangzhou First Applied Material Co., Ltd., Hangzhou, Zhejiang 311300 (CN)
(72) Inventor: LIN, Weihong, Hangzhou, Zhejiang 311300 (CN); LI, Bogeng, Hangzhou, Zhejiang 311300 (CN); HOU, Hongbing, Hangzhou, Zhejiang 311300 (CN); WANG, Liang, Hangzhou, Zhejiang 311300 (CN); SANG, Yan, Hangzhou, Zhejiang 311300 (CN); XIONG, Xi, Hangzhou, Zhejiang 311300 (CN); ZHOU, Guangda, Hangzhou, Zhejiang 311300 (CN); LIN, Jianhua, Hangzhou, Zhejiang 311300 (CN)
(74) Representative: Studio Torta S.p.A.
(86) International application number: PCT/CN2017/114440
(87) International publication number: WO 2018/157640

(57) **Abstract**

A highly reflective gain type photovoltaic packaging adhesive film and usage are provided. The packaging adhesive film is composed of an packaging layer and a reflecting layer, wherein the packaging layer has a thickness of 200 to 500 µm, and is made by mixing a first primary resin, a modified auxiliary, an ultraviolet auxiliary, an anti-thermal oxidation ageing agent and an initiator and melting and coat casting the same at 60° C to 200° C to form a film; and the reflecting layer has a thickness of 5 to 200 µm and is made by mixing a second primary resin, an auxiliary resin, a first filler, a second filler, modified auxiliary, a diluent and an ultraviolet auxiliary, an anti-thermal oxidation ageing agent and an initiator and coating the same on the surface of the packaging layer and curing the same at 30°C to 150°C. With a simple preparation process, a low cost, and an excellent product performance, the packaging film not only provides an effective gain effect for a double-sided crystal silicon battery module, but also provides a basis for optimizing the cost of the gain-type packaging material for a single-sided crystal silicon battery module, and at the same time, providing a guarantee for reliability of crystal silicon photovoltaic modules in long-term outdoor application.

## Description

### TECHNICAL FIELD

The present disclosure relates to the field of photovoltaic encapsulating materials, and particularly, to a high reflection gain type photovoltaic encapsulating film.

### BACKGROUND

Photovoltaic power generation is a process that utilizes the photoelectric effect to directly convert solar radiation energy into electric energy. A basic device for photoelectric conversion is a solar cell having three major advantages: permanency, cleanliness and flexibility. The solar cell, due to its long service life, can be used for a long period by one-time investment as long as the sun exists. Compared with thermal power generation and nuclear electric power generation, the solar cell is popular in national business organizations due to its simple and convenient production process, high safety during the preparation process and high reproducibility, thereby having broad development prospects.

A photovoltaic power generation system consists of a solar cell module, a solar controller, a storage cell (group), and a sun-tracking control system, in which a photovoltaic module is the core part of the solar power generation system and also is the highest value part of the solar power generation system. Since it undertakes a role of converting the solar radiation into electric energy, or sending it to the storage cell for storage, or driving the loads to work, the quality and cost of the entire power generation system depends upon the quality and cost of the photovoltaic module. In view of the compositional structure, a crystalline silicon photovoltaic module is generally composed of a low-iron tempered glass, a front-layer encapsulating film, a single silicon cell, a back-layer encapsulating film and a photovoltaic backing plate, in which the encapsulating films are located on both sides of the silicon cell to protect the silicon cell.

With the continuous improvement of photovoltaic power generation technology, a popularization process of the photovoltaic power generation system is accelerated, not only in the cost reduction of raw and auxiliary materials, but also in the advance of quality and efficiency improvement and functionalization of the materials. In terms of technology innovation of silicon cells, a double-sided cell having two high-efficiency sides (23% front & 19% back) is of one of the most promising high-efficiency cell technologies. After several years of development, the domestic manufacture of the double-sided cell keep making progress. There are already many enterprises with mass production scale in China in 2016. However, the encapsulating materials for the double-sided cell module did not greatly improved yet, and thus the conventional encapsulating method of glass components, i.e., the double glass and the transparent encapsulating film, is still used for encapsulating. This encapsulating method results in a relatively large encapsulating loss. The reason is mainly in that a part of light is transmitted through gaps between the silicon cells, and thus cannot reach the surface of the silicon cell to be utilized. For a photovoltaic module having 60 silicon cells, if a distance between the silicon cells is 2mm to 4mm, the area that is uncovered by the silicon cells accounts for more than 2% of the total area of the photovoltaic module. That is, more than 2% of sunlight cannot be absorbed and utilized by the silicon cells. Therefore, the materials other than the silicon cells are designed with respect to their light efficiency, and the gap area between the silicon cells is utilized in an appropriate way, which will play an important role in improving the double-sided efficiency of the double-sided cell.

Regarding a single-sided power generation cell, the traditional gain mode of the encapsulating material is to produce the white encapsulating material. For example, the patent CN203639397U adopts a double-layered structure, and CN104497899A adopts a front pre-crosslinking mode. Through these methods, the encapsulating materials having a higher reflection performance can be obtained, but the cost of raw material is relatively high, and the contribution to the reduction in levelized cost of energy is smaller.

Therefore, the most urgent problem to be solved in auxiliary materials required for the crystalline silicon cell photovoltaic module, and particularly in the double-sided cell module encapsulating industry is to develop a high reflection gain type photovoltaic encapsulating film, which not only has a high reflection performance at the gap between the silicon cells, but also has a significant cost advantage, and at the same time, also has excellent long-term stability in terms of encapsulating performance, heat resistance, insulation property, aging resistance and the like.

### SUMMARY

A purpose of the present disclosure is to provide a high reflection gain type photovoltaic encapsulating film and uses thereof, in order to overcome the defects of the prior art. In the present disclosure, through a regular-shaped high reflection structure design, a very high local reflection performance in the visible light and near-infrared regions can be achieved, which not only has an obvious gain effect on the photoelectric conversion efficiency of a double-sided cell, but also greatly reduces the cost of the encapsulating material of a single-sided power generation cell, and at the same time, has excellent long-term reliability in terms of encapsulating performance, heat resistance, insulation property, aging resistance, and the like.

The purpose of the present disclosure is achieved by the following technical solution of a high reflection gain type photovoltaic encapsulating film. The high reflection gain type photovoltaic encapsulating film includes an encapsulating layer and a reflecting layer. The encapsulating layer has a thickness of 200µm to 500µm and is prepared by mixing 60 wt% to 90 wt% of a first matrix resin, 0.5 wt% to 30 wt% of a modified additive, 0.1 wt% to 10 wt% of an ultraviolet stabilizer, 0.1 wt% to 3 wt% of an anti-thermo-oxidative aging agent and 0.1 wt% to 3 wt% of an initiator, then melting at a temperature of 60°C to 200°C and casting into a film. The first matrix resin is prepared by copolymerizing ethylene and one or two monomers selected from propylene, butene, heptene, octene, norbornene, vinyl acetate, methyl acrylate, and methyl methacrylate. The reflecting layer has a thickness of 5 to 200µm, and is prepared by mixing 60 wt% to 85 wt% of a second matrix resin, 3 wt% to 30 wt% of an auxiliary resin, 3 wt% to 30 wt% of a first filler, 0 wt% to 20 wt% of a second filler, 0.5 wt%to 10 wt% of a modified additive, 0.5 wt% to 20 wt% of a diluent, 0 wt%to 1 wt% of an ultraviolet stabilizer, 0.001 wt% to 5 wt% of an anti-thermo-oxidative aging agent and 0.001 wt% to 5 wt% of an initiator, then coating the mixture on a surface of the encapsulating layer and then curing at a temperature of 30°C to 150°C

Further, the second matrix resin is composed of one or more, mixed in any ratio, of a hydroxy acrylic resin, a hydroxyl-terminated polyolefin resin, a polycarbonate diol, a polycaprolactone diol, and polytetrahydrofuran diol; the auxiliary resin is composed of one or more, mixed in any ratio, of a bisphenol A type epoxy resin, a phenolic epoxy resin, a bisphenol A type epoxy vinyl ester resin, a novolac epoxy vinyl ester resin, an acrylic vinyl ester resin, and a polyurethane vinyl ester resin.

Further, the first filler is formed by mixing 0 w% to 40 w% of one or more selected from flake-like wet mica powder, talc powder, calcined kaolin, zinc oxide and montmorillonite that have a particle diameter in a range of 1 um to 40 um, 0 to 40 wt% of one of spherical glass microbeads, ceramic microbeads, aluminium oxide, magnesium oxide, boron nitride and zinc oxide, having a particle diameter in a range of 1 um to 50 um, and 20 wt% to 100 wt% of titanium dioxide having a particle diameter in a range of 0.2 um to 1.0 um; the second filler is composed of one or more, mixed in any ratio, of polymethyl methacrylate micropowder, polyamide micropowder, polyester micropowder, polystyrene micropowder, polyethylene micropowder and polypropylene micropowder that have a particle diameter ina range of 5um to 100um.

Further, the modified additive is composed of one or more, mixed in any ratio, of 3-(methacryloyl chloride)propyltrimethyloxysilane, vinyltriethoxysilane, vinyltrimethoxysilane, vinyl tri(β-methoxy ethoxy)silane, N-(2-aminoethyl-3-aminopropyl)trimethoxysilane, and 3-(2,3-epoxypropoxy)propylmethyldiethoxysilane. Further, the diluent is composed of one or more, mixed in any ratio, of alkyl acrylate, ether acrylate, hydroxy acrylate, diol diacrylate, trihydroxy triacrylate, glycidyl acrylate, ethoxylated bisphenol A acrylate, alkyl methacrylate, ether methacrylate, hydroxy methacrylate, diol dimethacrylate, trihydroxy trimethacrylate, glycidyl methacrylate, and ethoxylated bisphenol A methacrylate.

Further, patterns of the reflecting layer are regularly arranged and are consistent with shapes of gaps between silicon cells, and the reflecting layer is coated through one of anilox coating, mask coating, spray coating, transfer printing modes and the like.

Further, the curing of the reflecting layer adopts one or more of heat curing, radiation curing, ultraviolet curing, and microwave curing.

A use of the high reflection gain type photovoltaic encapsulating film described above, in which the high reflection gain type photovoltaic encapsulating film is used for encapsulating a crystalline silicon cell photovoltaic module, the module having an improved power by increasing a light reflectivity of a gap between silicon cells.

Further, the crystalline silicon cell photovoltaic module is preferably a front-layer photovoltaic module generating electricity on both the front side and the back side.

Further, the high reflection gain type photovoltaic encapsulating film is used as a front-layer encapsulating film or a back-layer encapsulating film; in use for encapsulating the photovoltaic module, a front panel glass, the front-layer encapsulating film, silicon cells, the back-layer encapsulating film and a back panel transparent material are sequentially laminated, put in a laminator and laminated at a temperature of 140°C to 160°C for 5 to 18 minutes; the back panel transparent material is glass or a transparent photovoltaic backing plate.

The beneficial effects of the present disclosure are mainly embodied in that: by combining the encapsulating layer and the reflecting layer that are made of two different materials, the encapsulating film having the high reflection performance at the gap between silicon cells and the high transparency of the region of the silicon cells is prepared by manufacturing processes of extrusion, film casting, high reflection coating and pre-curing. The base material of the encapsulating film is a polyolefin copolymer, which has a high transmittance of more than 90% and is conducive to passing of the sunlight from the front panel glass in the region of silicon cell to the surface of silicon cell through the encapsulating film at a lower light loss; the encapsulating film at the gap between the silicon cells adopts a high reflection design, has reflectivity of more than 80%, and thus can effectively reflect the sunlight at the gap between the silicon cells back to the inner surface of the front panel glass and then be absorbed by the surface of the silicon cell, thereby increasing the power gain by more than 2% for the photovoltaic module that can generate electricity on both sides. When the encapsulating material is applied to a single-sided power generation photovoltaic module, it can greatly reduce the cost of the reflecting material to reduce the levelized cost of energy of a photovoltaic power generation system end. In addition, the encapsulating film also has excellent comprehensive performances in terms of encapsulating performance, thermal stability, insulating property and weather resistance, and thus the photovoltaic encapsulating film can protect the silicon cells, and provide long-term reliability for the photovoltaic module.

### DESCRIPTION OF DRAWINGS

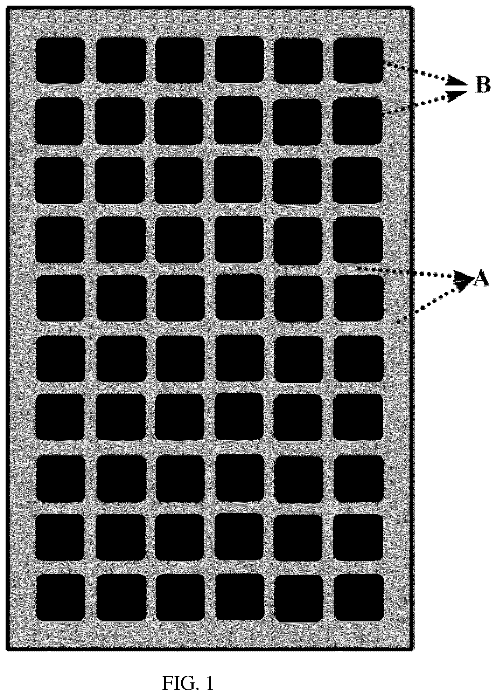

FIG. 1 is a schematic diagram of a high reflection gain type photovoltaic encapsulating film for encapsulating a double-sided power generation cell module according to the present disclosure;

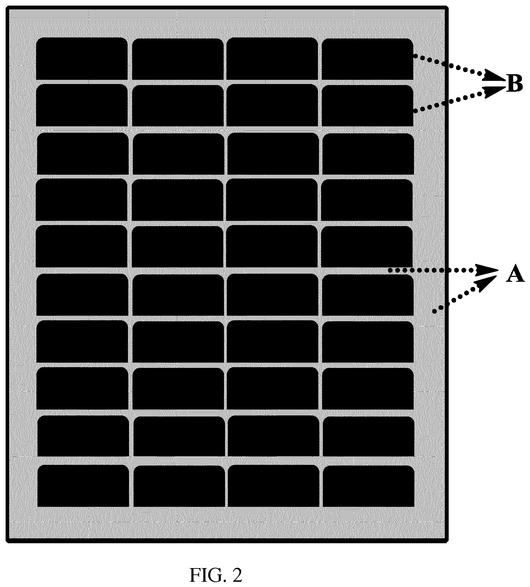

FIG. 2 is a schematic diagram of a high reflection gain type photovoltaic encapsulating film for encapsulating a half cell module according to the present disclosure; and

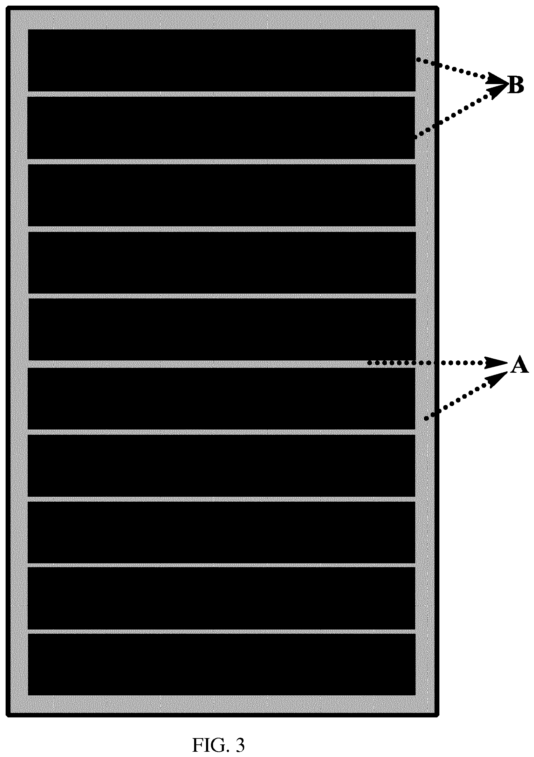

FIG. 3 is a schematic diagram of a high reflection gain type photovoltaic encapsulating film for encapsulating a laminated cell module according to the present disclosure.

In the above figures, A is a high reflection region of the encapsulating film, and B is a high light-transmittance region of the encapsulating film.

### DESCRIPTION OF EMBODIMENTS

The present disclosure will be further described below in conjunction with the embodiments, but the scope of the present disclosure is not only limited to the embodiments. The shape of a reflection region can be designed according to the design of a silicon cell and a photovoltaic module, and can be applied to modules of double-sided power generation cell, single-sided power generation cell, laminated cell and half cell.

It should be noted that the performance indexes of a photovoltaic encapsulating film were measured by the methods as described below:

### 1. Reflectivity and light transmittance

The test method refers to a spectrophotometer method with an integrating sphere in the standard GB/T 29848 "ethylene-vinyl acetate copolymer (EVA) film for photovoltaic module encapsulating".
Test instrument: UV-visible spectrophotometer.
Test conditions: 380 nm to 1100 nm.

### 2. Volume resistivity

The test method refers to the standard GB/T 29848 "ethylene-vinyl acetate copolymer (EVA) film for photovoltaic module encapsulating".
Sample size: 100 mm ^{∗} 100 mm.
Test conditions: test voltage 1000V.

### 3. Degree of crosslinking

The test method refers to the standard GB/T 29848 "ethylene-vinyl acetate copolymer (EVA) film for photovoltaic module encapsulating".
Sample size: 100 mm ^{∗} 100 mm.
Test conditions: test voltage 1000V.

### 4. Shrinkage ratio

The test method refers to the standard GB/T 29848 "ethylene-vinyl acetate copolymer (EVA) film for photovoltaic module encapsulating".
Sample size: 100 mm ^{∗} 100 mm.
Test conditions: 120°C, 3 min.

### 5. Glass/EVA peeling strength

The test method refers to the standard GB/T 29848 "ethylene-vinyl acetate copolymer (EVA) film for photovoltaic module encapsulating".
Sample size: 300 mm ^{∗} 10 mm.
Stretching speed: 100 mm/min.

### 6. Constant resistance to heat and moisture aging

The test method refers to the standard GB/T 29848 "ethylene-vinyl acetate copolymer (EVA) film for photovoltaic module encapsulating".
Test conditions: +85°C, relative humidity 85%.

The yellowness indexes (ΔYI) of each sample before and after the test were measured according to the national standard GB 2409 "yellowness index test method of plastics".

### 7. Maximum power

The test method refers to the standard IEC61215 "ground crystalline silicon photovoltaic module - design authentication and type approval".
Sample size: 60 double-sided silicon cells, manufactured by Jolywood Sunwatt Co., Ltd.
Test conditions: AM 1.5, irradiance 1000 W/m², +25°C, 50% RH.

### Example 1:

The manufacturing process of the encapsulating film is as follows:
First, 85wt% of ethylene-vinyl acetate copolymer (DuPont, USA), 10wt% of 3-(methacryloyl chloride)propyltrimethyloxysilane (Shanghai Chunall International Trade Co., Ltd.) as a modified additive, 2wt% of 2-(2'-hydroxy-3'-tert-butyl-5'-methylphenyl)-5-chlorobenzotriazole (Jinan Bondor Chemical Technology Co., Ltd.) as an UV stabilizer, 1.5wt% of 2,6-di-tert-butyl-4-methylphenol (Shenghe Chemical Co., Ltd.) as an anti-thermo-oxidative aging agent, and 1.5wt% of benzoperoxide (Chengdu Grecia Chemical Technology Co., Ltd.) as initiator were uniformly mixed and extruded at a temperature of 60°C to 90°C, and then subjected to film casting to obtain an encapsulating layer having a thickness of 450µm.

Then, a reflecting layer having a thickness of 160µm was sprayed and coated on one side of the encapsulating layer along a coating line which pre-designed the shape of the reflection region. The components of the coating material of the reflecting layer are 75 wt% of hydroxy acrylic resin (Mitsui Chemical Co., Ltd., Japan), 5 wt% of bisphenol A types epoxy resin E51 (Shanghai Huichuang Trade Co., Ltd.), 5 wt% of titanium dioxide CR-60-2 (Ishihara Co., Ltd., Japan), 3wt% of 3-(methacryloyl chloride)propyltrimethyloxysilane (Shanghai Chunall International Trading Co., Ltd.) as a modified additive, 11.3wt% of hydroxyethyl acrylate (Jiangyin Zefeng Chemical Co., Ltd.) as a diluent, 0.3wt% of 2-hydroxy-4-methoxybenzophenone (Jinan Bondor Chemical Technology Co., Ltd.) as an UV stabilizer, 0.3 wt% of tris(2,4-di-tert-butylphenyl) phosphite (Shenghe Chemical Co., Ltd.) as an anti-thermo-oxidative aging agent, and 0.1 wt% of benzoyl peroxide (Chengdu Grecia Chemical Technology Co., Ltd.) as an initiator. The raw materials were uniformly dispersed, coated on the encapsulating layer, and cured by radiation at a temperature of 60°C to 100°C for 2 min to obtain a high reflection gain type encapsulating film S1.

### Example 2:

First, 60 wt% of ethylene-octene copolymer (Dow Chemical, USA), 10wt% of 3-(2,3-epoxypropoxy)propylmethyldiethoxysilane (Jinan Langhua Chemical Co., Ltd.) and 20 wt% of vinyl trimethoxysilane (Jinan Langhua Chemical Co., Ltd.) as modified additives, 6 wt% of 2,4-dihydroxybenzophenone (Shanghai Zhixin Chemical Co., Ltd.) as an UV stabilizer, 3 wt% of 9,10-dihydro-9-oxa-10-phosphaphenanthrene-10-oxide (Dongguan Walixi Chemical Co., Ltd.), and 1 wt% of initiator 2,5-dimethyl-2,5-di(tert-butylperoxy)hexane (Guangzhou Qiansheng Trade Co., Ltd.) as an anti-thermo-oxidative aging agent were uniformly mixed, extruded at a temperature of 80°C to 120°C, and then subjected to film casting to obtain an encapsulating layer having a thickness of 200µm.

Then, a reflecting layer having a thickness of 5µm was anilox coated on one side of the encapsulating layer along a coating line which pre-designed the shape of the reflection region. The components of the coating material of the reflecting layer are 60 wt% of polycaprolactone diol (Daicel Co., Ltd., Japan), 6 wt% of acrylic vinyl ester resin (Mitsubishi Corporation, Japan), 4 wt% of mica powder (Dongjia Chemical Materials Co., Ltd.), 8 wt% of ceramic microbeads (Suzhou Maiang New Material Co., Ltd.), 18 wt% of titanium dioxide R902 (DuPont, USA), 1 wt% of 3-(2,3-epoxypropoxy)propylmethyldiethoxysilane (Shanghai Chunall International Trade Co., Ltd.) as a modified additive, 2.8 wt% of trihydroxytriacrylate (Jiangyin Zefeng Chemical Co., Ltd.) as a diluent, 0.15 wt% of 2,2'-methylenebis-(4-methyl-6-tert-butylphenol) (Shenghe Chemical Co., Ltd.) as an anti-thermo-oxidative aging agent, and 0.05 wt% of 2-hydroxy-2-methyl-1-[4-(2-hydroxyethoxy)phenyl]-1-propanone (Chengdu Grecia Chemical Technology Co., Ltd.) as an initiator. The raw materials were uniformly dispersed, coated on the encapsulating layer, and cured with UV at a temperature of 60°C to 100°C for 1 min to obtain a high reflection gain type encapsulating film S2.

### Example 3:

First, 70 wt% of ethylene-methyl acrylate copolymer (DuPont Chemical Co., Ltd., USA), 18 wt% of vinyl trimethoxysilane (Shanghai Chunall International Trade Co., Ltd.) as a modified additive, 8 wt% of 2-[4-[2-hydroxy-3-dodecyloxypropyl]oxy]-2-hydroxyphenyl]-4,6-bis(2,4-dimethylphenyl)-1,3,5-triazine (Jinan Bondor Chemical Technology Co., Ltd.) as an UV stabilizer, 2.5 wt% of 2-[4-[2-hydroxy-3-dodecyloxypropyl]oxy]-2-hydroxyphenyl]-4,6-bis(2,4-dimethylphenyl)-1,3,5-triazine (Shenghe Chemical Co., Ltd.) as an anti-thermo-oxidative aging agent, and 1.5 wt% of o,o-tert-amyl-o-(2-ethylhexyl)-mono-peroxycarbonate (Chengdu Grecia Chemical Technology Co., Ltd.) as an initiator were uniformly mixed, extruded at a temperature of 80°C to 120°C, and then subjected to film casting to obtain an encapsulating layer having a thickness of 200µm.

Then, a reflecting layer having a thickness of 180µm was coated with a mask on one side of the encapsulating layer along a coating line which pre-designed the shape of the reflection region. The components of the coating material of the reflecting layer are 85 wt% of hydroxyl-terminated polyolefin resin (Mitsubishi Corporation, Japan), 5 wt% of bisphenol A epoxy vinyl ester resin (Jinan Yisheng Resin Co., Ltd.), 2 wt% of glass microbeads (Suzhou Maiang New Material Co., Ltd.), 3 wt% of titanium dioxide R706 (DuPont, USA), 2 wt% of polyethylene micropowder (Nanjing Jiazhong Chemical Technology Co., Ltd.), 0.5 wt% of vinyl trimethoxysilane (Nanjing Luoen Silicon Material Co., Ltd.) as a modified additive, 2 wt% of trihydroxy trimethacrylate (Shandong Senjie Chemical Co., Ltd.) as a diluent, 0.38 wt% of 2-hydroxy-4-n-octyloxybenzophenone (Guangzhou Zhenwei Chemical Technology Co., Ltd.) as an UV stabilizer, 0.119 wt% of 4,4'-p-isopropyldiphenyl C12-15-alcohol phosphite (Jinan Dongrun Refined Technology Co., Ltd.) as an anti-thermo-oxidative aging agent, and 0.001 wt% of azodiisobutyl nitrile (Jinan Yingxin Chemical Co., Ltd.) as an initiator. The raw materials were uniformly dispersed, coated on the encapsulating layer, and cured by microwaves at a temperature of 100°C to 150°C for 1.5 min to obtain a high reflection gain type encapsulating film S3.

### Example 4:

First, 65 wt% of ethylene-propylene copolymer (Dow Chemical, USA), 20 wt% of vinyl tri(β-methoxyethoxy)silicon (Nanjing Luoen Silicon Materials Co., Ltd.) as a modified additive, 10 wt% of bis(1,2,2,6,6-pentamethyl-4-piperidinyl)-sebacate/mono(1,2,2,6,6-pentamethyl-4-piperidinyl) sebacate compound (Jinan Langhua Chemical Co., Ltd.) as an UV stabilizer, 2.5 wt% of octadecyl-β-(4-hydroxy-3,5-di-tert-butyl-phenyl) propionate (Hangzhou Chuyuan Chemical Co., Ltd.) as an anti-thermo-oxidative aging agent, and 2.5 wt% of 2,5-dimethyl-2,5-bis(benzoyl peroxy)-hexane (BASF, Germany) as an initiator were uniformly mixed, extruded at a temperature of 150°C to 200°C, and then subjected to film casting to obtain an encapsulating layer having a thickness of 500µm.

Then, a reflecting layer having a thickness of 200µm was coated by a transfer printing manner on one side of the encapsulating layer along a coating line which pre-designed the shape of the reflection region. The components of the coating material of the reflecting layer are 70 wt% of polytetrahydrofuran diol (Mitsui Chemicals Co., Ltd., Japan), 3 wt% of polyurethane vinyl ester resin (Shanghai Fengbiao Chemical Technology Co., Ltd.), 3 wt% of titanium dioxide CR-60-2 (Ishihara Co., Ltd., Japan), 20 wt% of polystyrene micropowder (Shanghai Guangyun Industrial Co., Ltd.), 1 wt% of vinyl tri(β-methoxyethoxy) silane (Nanjing Luoen Silicon Materials Co., Ltd.) as a modified additive, 2.5 wt% of ethoxylated bisphenol A methacrylate (German Evonik Co., Ltd) as a diluent, 0.2 wt% of 2-[4-[2-hydroxy-3-dodecyloxypropyl]oxy]-2-hydroxyphenyl]-4,6-bis(2,4-dimethylphenyl)-1,3,5-triazine (Yongguang Chemical Co., Ltd., Taiwan) as an UV stabilizer, 0.299 wt% of β-dodecyl pentaerythritol thiopropionate (Shenghe Chemical Co., Ltd.) as an anti-thermo-oxidative aging agent, and 0.001 wt% of o,o-tert-butyl-o-isopropyl-mono-peroxycarbonate (Chengdu Grecia Chemical Technology Co., Ltd.) as an initiator. The raw materials were uniformly dispersed, coated on the encapsulating layer, and thermally cured at a temperature of 130°C to 150°C for 5 min to obtain a high reflection gain type encapsulating film S4.

### Example 5:

First, 90 wt% of ethylene-norbornene copolymer (Dow Chemical, USA), 6 wt% of 3-(2,3-epoxypropoxy)propylmethyldiethoxysilane (Hangzhou Zhijiang Silicone Chemical Co., Ltd.) as a modified additive, 2.5 wt% of poly(polysuccinic acid (4-hydroxy-2,2,6,6-tetramethyl-1-piperidineethanol) ester) (Yongguang Chemical Co., Ltd., Taiwan), 1 wt% of triethylene glycol bis(3-tert-butyl-4-hydroxy-5-methylphenyl)propionate (BASF, Germany) as an anti-thermo-oxidative aging agent, and 0.5 wt% of 2,4,6-trimethylbenzoyldiphenylphosphine oxide (BASF, Germany) as an initiator were uniformly mixed, extruded at a temperature of 120°C to 160°C, and then subjected to film casting to obtain an encapsulating layer having a thickness of 450µm.

Then, a reflecting layer having a thickness of 180µm was coated by spraying on one side of the encapsulating layer along a coating line which pre-designed the shape of the reflection region. The components of the coating material of the reflecting layer are 60 wt% of polycarbonate diol (Ube Co., Ltd., Japan), 3 wt% of polycarbonate diol (Huakai Resin Co., Ltd.), 10 wt% of titanium dioxide R960 (DuPont, USA), 2 wt% of polypropylene micropowder (Hangzhou Wannengda Technology Co., Ltd.), 10 wt% of N-(2-aminoethyl-3-aminopropyl)trimethoxysilane (Nanjing Lidong Chemical Co., Ltd.) as a modified additive, 10 wt% of glycidyl methacrylate (Shanghai Beihe Chemical Co., Ltd.) as a diluent, 1 wt% of 2-(2'-hydroxy-5'-tert-octylphenyl)benzotriazole (Hangzhou Jessica Chemical Co., Ltd.) as an UV stabilizer, 2.0 wt% of 1,3,5-trimethyl-2,4,6-tri(3,5-di-tert-butyl-4-hydroxybenzyl)benzene (Hangzhou Jessica Chemical Co., Ltd.) as an anti-thermo-oxidative aging agent, and 2.0 wt% of 2-hydroxy-2-methyl-1-[4-(2-hydroxyethoxy)phenyl]-1-propanone (BASF, Germany) as an initiator. The raw materials were uniformly dispersed, coated on the encapsulating layer, and sequentially subjected to thermal curing at a temperature of 100°C to 130°C for 2 min and UV curing at a temperature of 60°C to 100°Cfor 1 min to obtain a high reflection gain type encapsulating film S5.

### Comparative Example 1:

The commercially available photovoltaic encapsulating material F406S is of transparent type and has a thickness of 450µm.

The performances of the photovoltaic encapsulating films prepared in Examples 1, 2, 3, 4, and 5 and the material in Comparative Example 1 were tested. The results were shown in Table 1.

**Table 1: Performance parameters of the prepared photovoltaic encapsulating films**

| Performance parameters | Unit | Example 1 | Example 2 | Example 3 | Example 4 | Example 5 | Comparative Example 1 |
|---|---|---|---|---|---|---|---|
| Reflectivity in reflection region | / | 93.5% | 97.9% | 94.6% | 95.0% | 98.7% | 0.5% |
| Light transmittance in encapsulating region | / | 93.5% | 92.5% | 92.7% | 93.0% | 92.5% | 92.3% |
| Shrinkage ratio (MD/TD) | / | 1.5%/1.3% | 1.5%/1.3% | 1.5%/1.3% | 1.5%/1.3 % | 1.5%/1.3% | 1.5%/1.3 % |
| Volume resistivity | Ω .cm | 7.3^{∗}10 ¹⁶ | 1.5^{∗}10 ¹⁷ | 8.6^{∗}10¹⁷ | 7.5^{∗}10¹⁶ | 3.0^{∗}10¹⁷ | 3.5^{∗}10¹⁶ |
| Degree of crosslinking | / | 68.9% | 60.45% | 79.6.% | 55.6% | 89.6% | 80.3% |
| Peeling strength from glass | N/10 mm | 158.4 | 151.6 | 160.7 | 157.1 | 153.9 | 156.9 |
| Peeling strength after heat and moisture for 2000h | N/10 mm | 143.2 | 140.6 | 144.3 | 142.0 | 144.7 | 135.1 |
| Maximum power | W | 264.6 | 267.7 | 265.1 | 266.9 | 268.5 | 260.3 |

It can be seen from the data in the table that the high reflection gain type photovoltaic encapsulating film provided by the present disclosure has a high light transmittance in the encapsulating region and a high reflection performance in the reflection region, and provides a significant gain for the power of the double-sided cell photovoltaic module. In addition, it has very high reliability in terms of encapsulating performance, heat resistance and weather resistance, and thus can fully meet the requirements of double-sided cell encapsulating film materials. The material according to the present disclosure has the advantages of low material cost, simple and convenient preparation process and stable performances, thereby greatly improving the power generation efficiency of the double-sided and single-sided cell crystalline silicon photovoltaic modules, and providing important technical support for the photovoltaic modules with respect to the reduction of the auxiliary material cost and reduction of the levelized cost of energy

## Claims

1. A high reflection gain type photovoltaic encapsulating film, comprising:
an encapsulating layer; and
a reflecting layer,
wherein the encapsulating layer has a thickness of 200µm to 500µm and is prepared by mixing 60 wt% to 90 wt% of a first matrix resin, 0.5 wt% to 30 wt% of a modified additive, 0.1 wt% to 10 wt% of an ultraviolet stabilizer, 0.1 wt% to 3 wt% of an anti-thermo-oxidative aging agent and 0.1 wt% to 3 wt% of an initiator, then melting at a temperature of 60°C to 200°C and casting into a film; the first matrix resin is prepared by copolymerizing ethylene and one or two monomers selected from propylene, butene, heptene, octene, norbornene, vinyl acetate, methyl acrylate, and methyl methacrylate;
the reflecting layer has a thickness of 5 to 200µm, and is prepared by mixing 60 wt% to 85 wt% of a second matrix resin, 3 wt% to 30 wt% of an auxiliary resin, 3 wt% to 30 wt% of a first filler, 0 wt% to 20 wt% of a second filler, 0.5 wt%to 10 wt% of a modified additive, 0.5 wt% to 20 wt% of a diluent, 0 wt%to 1 wt% of an ultraviolet stabilizer, 0.001 wt% to 5 wt% of an anti-thermo-oxidative aging agent and 0.001 wt% to 5 wt% of an initiator, then coating the mixture on a surface of the encapsulating layer and then curing at a temperature of 30°Cto 150°C

2. The high reflection gain type photovoltaic encapsulating film according to claim 1, wherein the second matrix resin is composed of one or more, mixed in any ratio, of a hydroxy acrylic resin, a hydroxyl-terminated polyolefin resin, a polycarbonate diol, a polycaprolactone diol, and polytetrahydrofuran diol;
the auxiliary resin is composed of one or more, mixed in any ratio, of a bisphenol A type epoxy resin, a phenolic epoxy resin, a bisphenol A type epoxy vinyl ester resin, a novolac epoxy vinyl ester resin, an acrylic vinyl ester resin, and a polyurethane vinyl ester resin.

3. The high reflection gain type photovoltaic encapsulating film according to claim 1, wherein the first filler is formed by mixing 0 w% to 40 w% of one or more selected from flake-like wet mica powder, talc powder, calcined kaolin, zinc oxide and montmorillonite that have a particle diameter in a range of 1 um to 40 um, 0 to 40 wt% of one of spherical glass microbeads, ceramic microbeads, aluminium oxide, magnesium oxide, boron nitride and zinc oxide, having a particle diameter in a range of 1 um to 50 um, and 20 wt% to 100 wt% of titanium dioxide having a particle diameter in a range of 0.2 um to 1.0 um;
the second filler is composed of one or more, mixed in any ratio, of polymethyl methacrylate micropowder, polyamide micropowder, polyester micropowder, polystyrene micropowder, polyethylene micropowder and polypropylene micropowder that have a particle diameter in a range of 5um to 100um.

4. The high reflection gain type photovoltaic encapsulating film according to claim 1, wherein the modified additive is composed of one or more, mixed in any ratio, of 3-(methacryloyl chloride)propyltrimethyloxysilane, vinyltriethoxysilane, vinyltrimethoxysilane, vinyl tri(β-methoxy ethoxy)silane, N-(2-aminoethyl-3-aminopropyl)trimethoxysilane, and 3-(2,3-epoxypropoxy)propylmethyldiethoxysilane.

5. The high reflection gain type photovoltaic encapsulating film according to claim 1, wherein the diluent is composed of one or more, mixed in any ratio, of alkyl acrylate, ether acrylate, hydroxy acrylate, diol diacrylate, trihydroxy triacrylate, glycidyl acrylate, ethoxylated bisphenol A acrylate, alkyl methacrylate, ether methacrylate, hydroxy methacrylate, diol dimethacrylate, trihydroxy trimethacrylate, glycidyl methacrylate, and ethoxylated bisphenol A methacrylate.

6. The high reflection gain type photovoltaic encapsulating film according to claim 1, wherein patterns of the reflecting layer are regularly arranged and are consistent with shapes of gaps between silicon cells, and the reflecting layer is coated through one of anilox coating, mask coating, spray coating, and transfer printing modes.

7. The high reflection gain type photovoltaic encapsulating film according to claim 1, wherein the curing of the reflecting layer adopts one or more of heat curing, radiation curing, ultraviolet curing, and microwave curing.

8. A use of the high reflection gain type photovoltaic encapsulating film according to claim 1, wherein the high reflection gain type photovoltaic encapsulating film is used for encapsulating crystalline silicon cell photovoltaic modules , the modules having an improved power by increasing a light reflectivity of a gap between silicon cells.

9. The use according to claim 8, wherein the crystalline silicon cell photovoltaic module is preferably a bifacial photovoltaic module generating electricity on both the frontside and the back side of the cells.

10. The use according to claim 9, wherein the high reflection gain type photovoltaic encapsulating film is used as a front encapsulating film or a back encapsulating film; in use for encapsulating the photovoltaic module, a front panel glass, the front encapsulating film, silicon cells, the backencapsulating film and a back panel transparent material are sequentially laminated, put in a laminator and laminated at a temperature of 140°C to 160°C for 5 to 18 minutes; the back panel transparent material is glass or a transparent photovoltaic backing plate.
